# EUROPEAN PATENT SPECIFICATION

(11) **EP 3 053 196 B1**
(45) Date of publication and mention of the grant of the patent: **11.08.2021**
(21) Application number: 14847483.6
(22) Date of filing: 16.09.2014
(51) Int. Cl.: H01L 29/778, H01L 29/51, H01L 21/336, H01L 29/423, H01L 29/417, H01L 29/20

(54) **FIELD EFFECT TRANSISTOR AND METHOD**
FELDEFFEKTTRANSISTOR UND VERFAHREN
TRANSISTOR À EFFET DE CHAMP ET PROCÉDÉ ASSOCIÉ

(30) Priority: 30.09.2013 US 201314041667; 29.05.2014 US 201414290029
(43) Date of publication of application: 10.08.2016
(73) Proprietor: HRL Laboratories, LLC, Malibu, CA 90265-4799 (US)
(72) Inventor: CHU, Rongming, Agoura Hills, California 91301 (US); CHEN, Mary Y., Oak Park, California 91377 (US); LI, Zijian "Ray", Oak Park, California 91377 (US); BOUTROS, Karim S., Moorpark, California 93021 (US); CHEN, Xu, Los Angeles, California 90034 (US); BROWN, David F., Woodland Hills, California 91303 (US); WILLIAMS, Adam J., Los Alamitos, California 90720 (US)
(74) Representative: Richards, John
(86) International application number: PCT/US2014/055881
(87) International publication number: WO 2015/047797

(56) References cited:
- JP-A- 2012 156 164
- JP-A- 2013 140 835
- US-A1- 2005 056 893
- US-A1- 2010 025 730
- US-A1- 2010 025 730
- US-A1- 2010 090 251
- US-A1- 2011 133 205
- US-A1- 2013 001 646
- PUNEET SRIVASTAVA ET AL: "Silicon Substrate Engineered High-Voltage High-Temperature GaN-DHFETs", IEEE TRANSACTIONS ON ELECTRON DEVICES, IEEE SERVICE CENTER, PISACATAWAY, NJ, US, vol. 60, no. 7, July 2013 (2013-07), pages 2217-2223, XP011515300, ISSN: 0018-9383, DOI: 10.1109/TED.2013.2263253
- None

## Description

### TECHNICAL FIELD

This disclosure relates to III-Nitride field effect transistors (FETs) and in particular to insulated gates for FETs. Otherwise stated, this writing pertains to III-Nitride insulating-gate transistors with passivation.

### BACKGROUND

III-nitride transistors are promising for high-speed and high-power applications, such as power switches, which may be used for motor drivers and power supplies, among other applications.

Many of these applications require the transistor to operate in normally-off mode. Normally-off mode operation can be realized by a number of approaches, but typically at the penalty of higher on-resistance and lower output-current.

US 2010/025730 discloses a normally-off semiconductor devices are provided. A Group III-nitride buffer layer is provided. A Group III-nitride barrier layer is provided on the Group III-nitride buffer layer. A non-conducting spacer layer is provided on the Group III-nitride barrier layer. The Group III-nitride barrier layer and the spacer layer are etched to form a trench. The trench extends through the barrier layer and exposes a portion of the buffer layer. A dielectric layer is formed on the spacer layer and in the trench and a gate electrode is formed on the dielectric layer. Related methods of forming semiconductor devices are also provided herein.

JP 2013/140835 discloses a semiconductor device capable of being manufactured with ease, and that uses a nitride semiconductor having a gate insulating film and whose gate threshold voltage is positive. It comprises a semiconductor device having: a nitride semiconductor layer formed on a substrate; an insulating film formed on the nitride semiconductor layer; a semiconductor film formed on the insulating film; and an electrode formed on the semiconductor film. The semiconductor film contains fluorine.

High-power applications with normally-off III-nitride transistors need an insulated gate to achieve low leakage current, and an effective passivation dielectric to achieve minimal trapping effects.

The best-suited gate insulator and the best-suited passivation dielectric are usually different materials, which may cause processing compatibility problems. For example, plasma-enhanced chemical vapor deposition (PECVD) SiN film is a known good passivation material, while metal organic chemical vapor deposition (MOCVD) AlN is a known good gate insulator material.

Unfortunately, the process of forming MOCVD AlN can degrade a PECVD SiN film that is already deposited on the semiconductor.

What is needed is a device structure and method of making the device that resolves this process incompatibility and that has a high breakdown voltage and low on resistance. The embodiments of the present writing consider these and other needs.

### SUMMARY

According to the invention, there is provided a method of fabricating a normally-off III-nitride field-effect transistor according to claim 1.

This method of fabricating a field-effect transistor (FET) comprises in particular forming a plurality of semiconductor layers, forming a source electrode contacting at least one of the semiconductor layers, forming a drain electrode contacting at least one of the semiconductor layers, forming a first dielectric layer covering a portion of semiconductor top surface between the source electrode and the drain electrode, forming a first trench extending through the first dielectric layer and having a bottom located on a top surface of the semiconductor layers or within one of the semiconductor layers, forming a second dielectric layer lining the first trench and covering a portion of the first dielectric layer, forming a third dielectric layer over the semiconductor layers, the first dielectric layer, and the second dielectric layer, forming a second trench extending through the third dielectric layer and having a bottom located in the first trench on the surface of or within the second dielectric layer, and extending over a portion of the second dielectric on the first dielectric, and forming a gate electrode filling the second trench.

These and other features and advantages will become further apparent from the detailed description and accompanying figures that follow. In the figures and description, numerals indicate the various features, like numerals referring to like features throughout both the drawings and the description.

### BRIEF DESCRIPTION OF THE DRAWINGS

FIG. 1 shows a diagram of III-nitride field effect transistor that can be manufactured in accordance with the present invention;
FIG. 2 shows a typical off-state current voltage (IV) characteristic of a FET that can be manufactured in accordance with the present invention;
FIG. 3 shows a typical dynamic current voltage (IV) characteristic of a FET that can be manufactured in accordance with the present invention;
FIG. 4 shows a diagram of another field effect transistor that can be manufactured in accordance with the present invention;
FIG. 5 shows a diagram of yet another field effect transistor that can be manufactured in accordance with the present invention;
FIG. 6 shows a diagram of still another field effect transistor that can be manufactured in accordance with the present invention; and
FIG. 7 shows a diagram of a gate insulator stack used in a field effect transistor that can be manufactured in accordance with the present invention.

### DETAILED DESCRIPTION

In the following description, numerous specific details are set forth to clearly describe various specific embodiments disclosed herein. One skilled in the art, however, will understand that the presently claimed invention may be practiced without all of the specific details discussed below. In other instances, well known features have not been described so as not to obscure the invention.

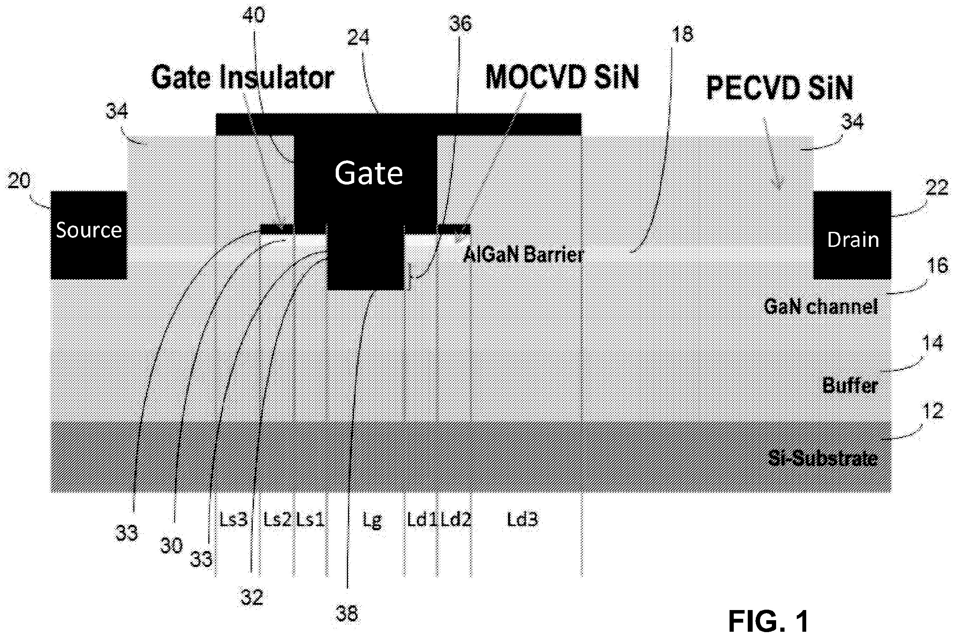

FIG. 1 shows a diagram of III-nitride field effect transistor (FET) in accordance with the present disclosure. The FET has a buffer layer 14 formed on a substrate 12. A channel layer 16 is formed on the buffer layer 14 and a barrier layer 18, is formed on the channel layer 16.

The substrate 12 material may be silicon (Si), silicon carbide (SiC), sapphire (Al₂O₃), gallium nitride (GaN), or aluminum nitride (AlN).

The buffer layer 14 may be a stack of III-Nitride materials grown on the substrate 12 by chemical vapor deposition or molecular beam epitaxy.

The channel layer 16 may be a III-Nitride material, such as GaN, grown on the buffer layer 14 by chemical vapor deposition or molecular beam epitaxy. Typically the channel layer 16 is an undoped GaN layer with the thickness ranging from 5 nanometers to a few micrometers.

The barrier layer 18 may be 1-30 nanometers thick and may typically be only 5 nm thick. The barrier layer 18 may be AlGaN, with a 25% A1 composition.

A source electrode 20 and a drain electrode 22 are in contact with the channel layer 16 and extend through the barrier layer 18. The source electrode 20 and drain electrode 22 are on opposite ends of the channel layer 16.

A dielectric layer 30, which may be 1nm to 100nm thick and is typically 10nm thick, and which may be SiN, is deposited by metal organic chemical vapor deposition (MOCVD) on top of the AlGaN barrier layer 18. In a preferred embodiment the dielectric layer 30 is deposited by MOCVD at a temperature higher than 600 degrees C, and typically at 900 degrees C.

The dielectric layer 30 is patterned to be on top of the AlGaN barrier layer 18 in a gate area for a distance of Ls2, Ls1, Lg, Ld1 and Ld2, as shown in FIG. 1, between the source 20 and drain 22. In the embodiment of FIG. 1, the dielectric layer 30 is not in contact with either the source 20 or the drain 22.

A first gate trench 32 with a length of Lg, as shown in FIG. 1, is formed through the dielectric layer 30 and the barrier layer 18. The bottom 38 of the gate trench 32 is located within the channel layer 16, and extends below the barrier layer 18 and into the channel layer 16 by a vertical distance 36. This vertical distance 36 is between an interface of the barrier layer 18 and channel layer 16 and the bottom 38 of the gate trench 32, and is typically between 0 and 10 nanometers (nm). The vertical distance 36 needs to be equal or greater than 0 nm for normally-off operation, and needs to be as small as possible to in order to minimize the on-resistance.

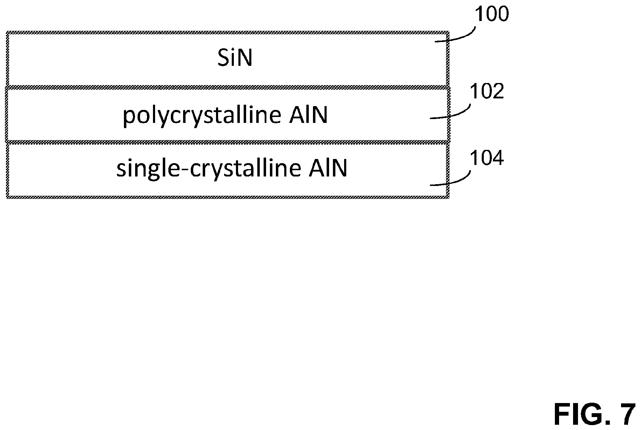

A gate insulator 33 is formed in the gate trench 32 and over the dielectric layer 30. As shown in FIG. 7, the gate insulator 33 includes a stack of: a layer of single-crystalline AlN 104 at the bottom of the gate trench 32, which may be up to 2nm thick and typically 1nm thick; a layer of polycrystalline AlN 102 on the single crystalline AlN layer, which is 1nm to 50nm thick and typically 10nm thick; and an insulating layer of SiN 100, which may be 1nm to 50nm thick and typically 10nm thick, formed on the polycrystalline AlN layer.

The single crystalline AlN 104 is grown at a temperature greater than 900C, and less than 1100C. The poly crystalline AlN 102 is grown at a temperature greater than 300C, and less than 600C.

The gate insulator 33 stack makes the FET a normally off FET. Under a positive gate bias the FET has a very low gate leakage, and a high-mobility electron channel is formed at the interface between the barrier layer 18 and the channel layer 16.

The single-crystalline AlN layer 104 of the gate insulator stack 33 provides a high-quality interface for electron transport in the channel layer 16. Furthermore, the single crystalline AlN layer 104 provides an energy barrier to prevent electron trapping into the poly-crystalline AlN layer 102. The thickness of the single crystalline AlN layer 104 is chosen to be thin enough, typically below 2nm, to avoid accumulation of channel electrons in absence of a positive gate bias.

The SiN layer 100 serves as a blocking layer to leakage paths through grain boundaries of the polycrystalline AlN layer 102.

The gate insulator 33 is formed in the trench 32 and over the dielectric layer 30. The gate insulator 33 and the dielectric layer 30 are removed in regions beyond the gate area of Ls2, Ls1, Lg, Ld1 and Ld2, as shown in FIG. 1.

A passivation dielectric 34, which may be SiN and have a thickness of 10nm to 500nm with a typical thickness of 100nm, is deposited by plasma-enhanced chemical vapor deposition (PECVD) over the barrier layer 18 between the source 20 and the drain 22, over the gate insulator 33 in the trench 32, and over the gate insulator 33 on the dielectric layer 30. In a preferred embodiment the passivation dielectric 34 is deposited by PECVD at a temperature lower than 500 degrees C, and typically at 300 degrees C.

A second gate trench 40 is formed in passivation dielectric 34 by etching and may have a length of the sum of Lg, Ls1 and Ld1, as shown in FIG. 1. The second gate trench 40 extends to the gate insulator 33 in the gate trench 32 and overlaps the gate insulator 33 on the dielectric layer 30 by a distance Ls1 and Ld1, as shown in FIG. 1. The gate insulator 33 on the dielectric layer 30 for distance Ls2 and Ld2 on either side of Ls1 and Ld1, as shown in FIG. 1, remains covered by the passivation layer 34.

A gate electrode 24 is formed within the second gate trench 40 and may extend over the passivation layer 34 partially toward the source electrode 20 by a distance Ls3, as shown in FIG. 1, and partially toward the drain electrode 22 by a distance Ld3, as shown in FIG. 1, to form an integrated gate field-plate. The gate electrode 24 may be any suitable metal.

As shown in FIG. 1, two types of dielectric are in contact with the AlGaN barrier layer 18 in the gate to drain region. The two types of dielectric are: a dielectric layer 30, which may be a SiN layer deposited by metal organic chemical vapor deposition (MOCVD), and a passivation dielectric layer 34, which may be a SiN layer deposited by plasma-enhanced chemical vapor deposition (PECVD).

Dielectric layer 30 is deposited prior to the deposition of the gate insulator layer stack 33. The dielectric layer 30 serves as a etch stop layer for the patterning of the gate insulator layer stack 33, and dielectric layer 30 can survive subsequent high-temperature steps, such as the deposition of gate insulator layer stack 33 and the alloying of source 20 and drain 22 contacts.

Dielectric layer 34 serves the purpose of mitigating trapping behaviors. Dielectric layer 34 is deposited after the deposition of gate insulator layer stack 33, to avoid the impact of high-temperature processing on the properties of dielectric layer 34.

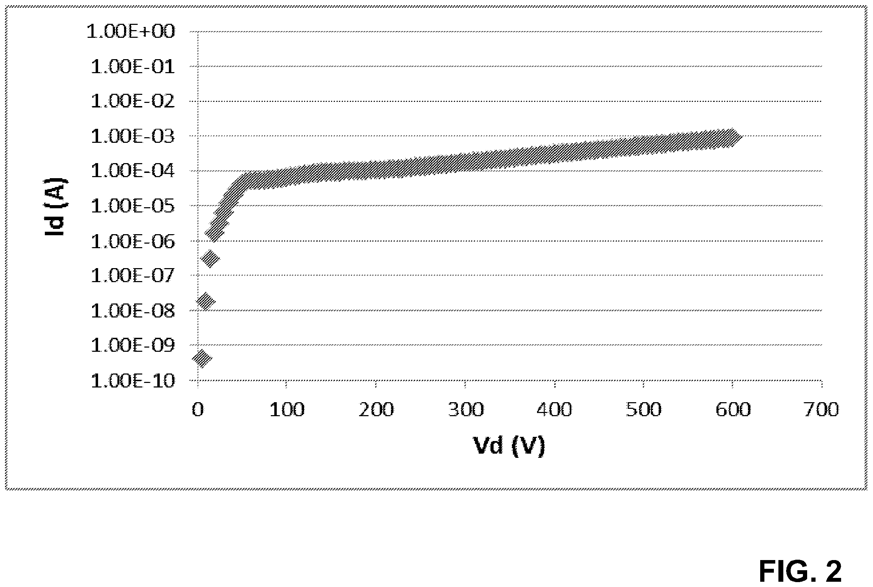

FIG. 2 shows a typical off-state current voltage (IV) characteristic of a FET in accordance with the present disclosure. As shown in FIG. 2, the off-state current is very low even at 600 volts, demonstrating the breakdown voltage is greater than 600 volts.

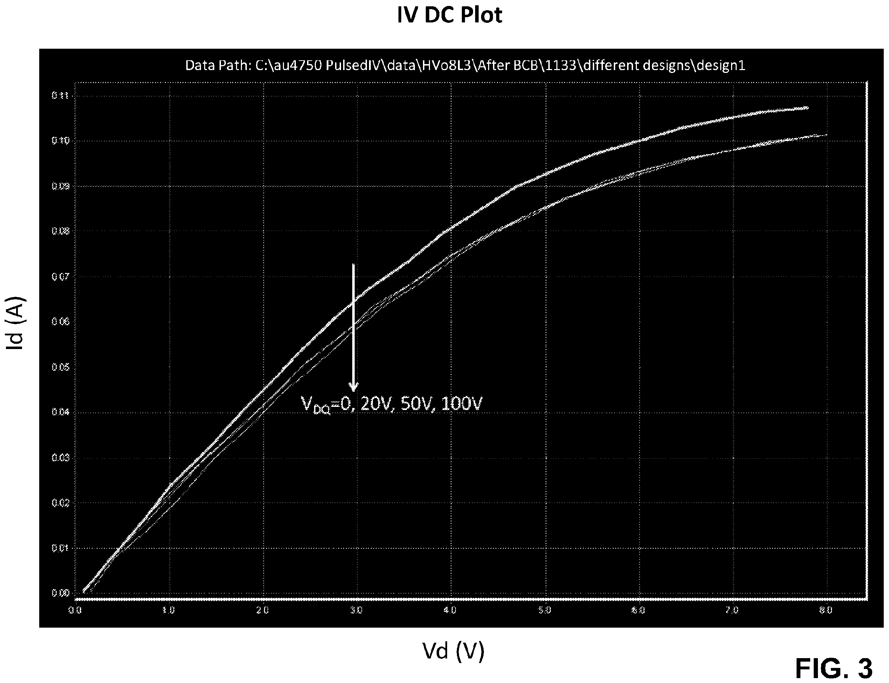

FIG. 3 shows a typical dynamic current voltage (IV) characteristic of a FET in accordance with the present disclosure, and the graph demonstrates that the on-resistance for a FET is only minimally degraded.

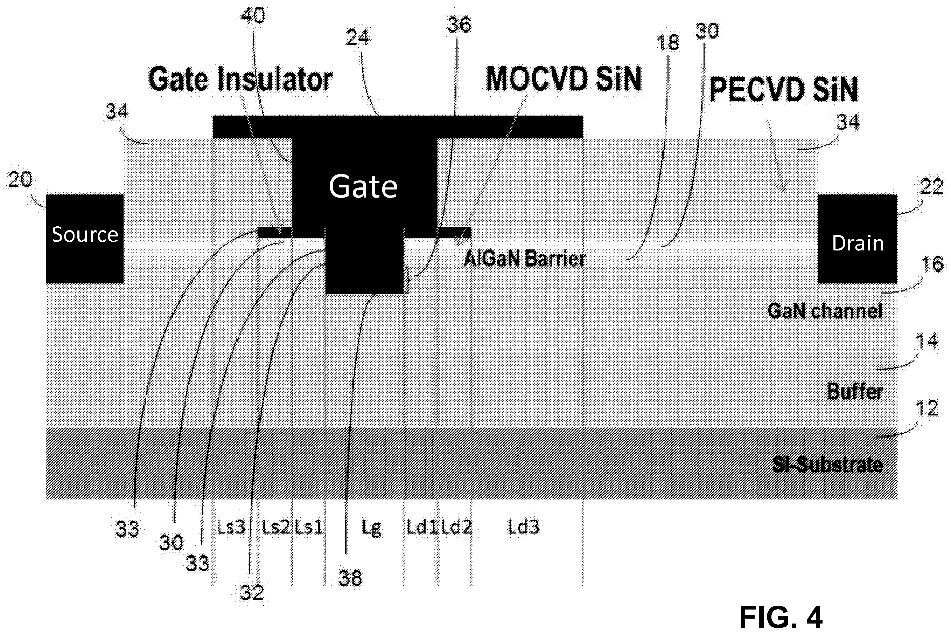

FIG. 4 shows a diagram of another field effect transistor in accordance with the present disclosure. The embodiment of FIG. 4 is similar to the embodiment of FIG. 1. However, in the embodiment of FIG. 4 the dielectric layer 30, which may be 1nm to 100nm thick and is typically 10nm thick, and which may be SiN, is deposited by metal organic chemical vapor deposition (MOCVD) on top of the AlGaN barrier layer 18 and extends from the source 20 to the drain 22, as shown in FIG. 4, rather than just in the gate area as shown in FIG. 1.

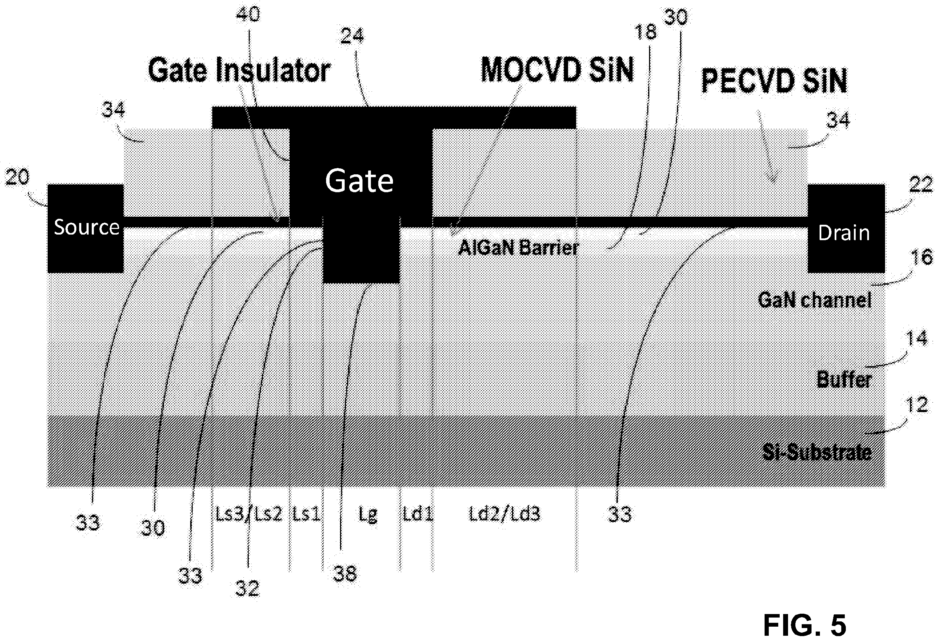

FIG. 5 shows a diagram of yet another field effect transistor in accordance with the present disclosure. The embodiment of FIG. 5 is similar to the embodiment of FIG. 4. However, in the embodiment of FIG. 5 the gate insulator stack 33 extends from the source 20 to the drain 22, as shown in FIG. 5, rather than just in the gate area as shown in FIG. 4.

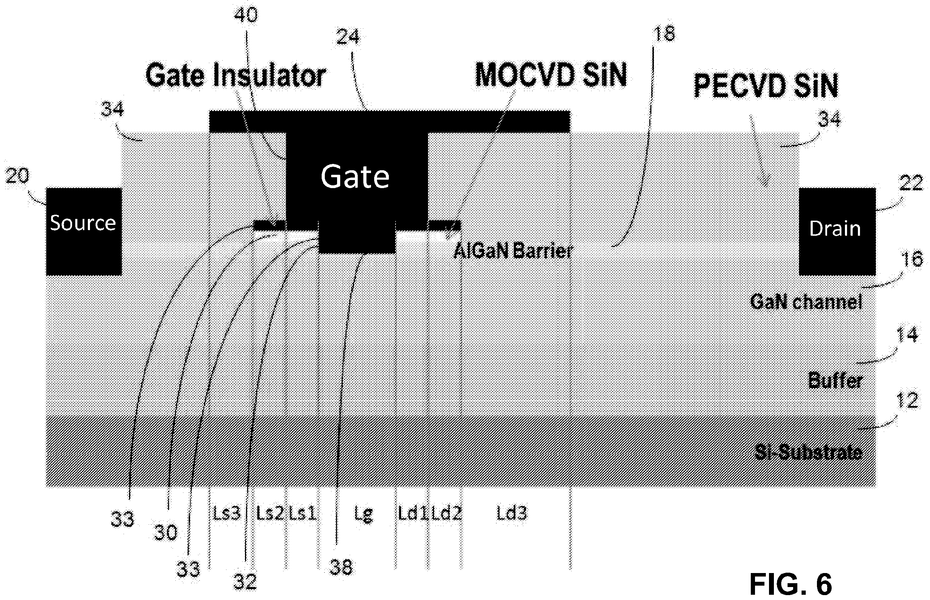

FIG. 6 shows a diagram of still another field effect transistor in accordance with the present disclosure. The embodiment of FIG. 6 is similar to the embodiment of FIG. 1. However, in the embodiment of FIG. 6 the bottom 38 of the gate trench 32 is located within the barrier layer 18, and does not extend below the barrier layer 18 into the channel layer 16. The gate trench 32 may also be only to the top surface of the barrier layer 18. Variations of the embodiment of FIG. 6 may also include an embodiment where the dielectric layer 30 extends from the source 20 to the drain 22, and another embodiment where both the dielectric layer 30 and the gate insulator stand extend from the source 20 to the drain 22.

Having now described the invention in accordance with the requirements of the patent statutes, those skilled in this art will understand how to make changes and modifications to the present invention to meet their specific requirements or conditions. Such changes and modifications may be made without departing from the scope of the invention as disclosed herein.

The foregoing Detailed Description of exemplary and preferred embodiments is presented for purposes of illustration and disclosure in accordance with the requirements of the law. It is not intended to be exhaustive nor to limit the invention to the precise form(s) described, but only to enable others skilled in the art to understand how the invention may be suited for a particular use or implementation. The possibility of modifications and variations will be apparent to practitioners skilled in the art. No limitation is intended by the description of exemplary embodiments which may have included tolerances, feature dimensions, specific operating conditions, engineering specifications, or the like, and which may vary between implementations or with changes to the state of the art, and no limitation should be implied therefrom. Applicant has made this disclosure with respect to the current state of the art, but also contemplates advancements and that adaptations in the future may take into consideration of those advancements, namely in accordance with the then current state of the art. It is intended that the scope of the invention be defined by the Claims as written and equivalents as applicable.

All elements, parts and steps described herein are preferably included. It is to be understood that any of these elements, parts and steps may be replaced by other elements, parts and steps or deleted altogether as will be obvious to those skilled in the art.

Broadly, this writing discloses at least the following:
A field-effect transistor (FET) includes a plurality of semiconductor layers, a source electrode and a drain electrode contacting one of the semiconductor layers, a first dielectric layer on a portion of a top semiconductor surface between the source and drain electrodes, a first trench extending through the first dielectric layer and having a bottom located on a top surface or within one of the semiconductor layers, a second dielectric layer lining the first trench and covering a portion of the first dielectric layer, a third dielectric layer over the semiconductor layers, the first dielectric layer, and the second dielectric layer, a second trench extending through the third dielectric layer and having a bottom located in the first trench on the second dielectric layer and extending over a portion of the second dielectric, and a gate electrode filling the second trench.

## Claims

1. A method of fabricating a normally-off III-nitride field-effect transistor comprising:
forming a plurality of semiconductor layers;
forming a source electrode (20) contacting at least one of the semiconductor layers;
forming a drain electrode (22) contacting at least one of the semiconductor layers;
forming a first dielectric layer (30) covering a portion of a top surface of the semiconductor layers between the source electrode (20) and the drain electrode (22);
forming a first trench (32) extending through the first dielectric layer (30) and having a bottom (38) located within one of the semiconductor layers;
forming a second dielectric layer (33) lining the first trench (32) and covering a portion of the first dielectric layer (30);
forming a third dielectric layer (34) over the semiconductor layers, the first dielectric layer (30), and the second dielectric layer (33);
forming a second trench (40) extending through the third dielectric layer (34) and having a bottom located in the first trench (32) on the surface of or within the second dielectric layer (33), and extending over a portion of the second dielectric layer (33) on the first dielectric layer (30); and
forming a gate electrode (24) filling the second trench (40);
wherein forming said second dielectric layer (33) comprises:
growing a single crystalline AlN layer (104) at the bottom (38) of the first trench (32) at a temperature greater than 900°C and less than 1100°C;
growing a polycrystalline AlN layer (102) at a temperature greater than 300°C and less than 600°C on the single crystalline AlN layer (104); and
forming an insulating layer comprising SiN on the polycrystalline AlN layer.

2. The method of claim 1 further comprising:
providing a substrate (12) comprising silicon, silicon carbide, sapphire, gallium nitride, or aluminum nitride;
wherein the plurality of semiconductor layers are on the substrate (12) and comprise:
a III-nitride channel layer (16); and
a barrier layer (18) over the channel layer (16);
wherein:
the channel layer (16) comprises GaN and has a thickness ranging from 5 nanometers to a few micrometers; and
the barrier layer (18) comprises AlGaN having a thickness ranging from 1-30 nanometers and having a 25% Al composition; and
wherein a distance (36) between an interface of the channel layer (16) and the barrier layer (18) and the bottom (38) of the first trench (32) is equal to or greater than 0 nanometers and less than or equal to 10 nanometers.

3. The method of claim 1 wherein:
forming the first dielectric layer (30) comprises depositing SiN at a temperature greater than 600 degrees centigrade by metal organic chemical vapor deposition; and
forming the third dielectric layer (34) comprises depositing SiN at a temperature lower than 500 degrees centigrade by plasma-enhanced chemical vapor deposition.

4. The method of claim 1 wherein:
the first dielectric layer (30) comprises SiN having a thickness of 1nm to 100nm; and
the third dielectric layer (34) comprises SiN having a thickness of 10nm to 500nm;
forming the second dielectric layer (33) further comprises forming the insulating SiN layer (100) with a thickness of 1nm to 50nm on the polycrystalline AlN layer (102).

5. The method of claim 1 wherein:
the single crystalline AlN layer (104) is up to 2nm thick; and
the polycrystalline AlN layer (102) is 1nm to 50nm thick.

6. The method of claim 1 wherein:
the first dielectric layer (30) is only formed in a gate area and the second dielectric layer (33) covers the first dielectric layer (30) in the gate area.

7. The method of claim 1 wherein:
the first dielectric layer (30) is formed to extend from the source electrode (20) to the drain electrode (22) and the second dielectric layer (33) covers the first dielectric layer (30) only in the gate area; or
the first dielectric layer (30) is formed to extend from the source electrode (20) to the drain electrode (22) and the second dielectric layer (33) covers the first dielectric layer (30) and extends from the source electrode (20) to the drain electrode (22).

8. The method of claim 1, wherein:
the first dielectric layer (30) provides an etch stop for patterning of the second dielectric layer (33); and wherein:
forming the first trench (32) comprises etching; and
forming the second trench (40) comprises etching and the second dielectric layer (33) provides an etch stop.

## Patentansprüche

1. Verfahren zur Herstellung eines im Normalzustand ausgeschalteten III-Nitrid-Feldeffekttransistors, wobei das Verfahren folgendes umfasst:
Ausbilden einer Mehrzahl von Halbleiterschichten;
Ausbilden einer Source-Elektrode (20), die in Kontakt mit mindestens einer der Halbleiterschichten steht;
Ausbilden einer Drain-Elektrode (22), die in Kontakt mit mindestens einer der Halbleiterschichten steht;
Ausbilden einer ersten dielektrischen Schicht (30), die einen Teil einer oberen Oberfläche der Halbleiterschichten zwischen der Source-Elektrode (20) und der Drain-Elektrode (22) bedeckt;
Ausbilden eines ersten Grabens (32), der sich durch die erste dielektrische Schicht (30) erstreckt und einen Boden (38) aufweist, der sich in einer der Halbleiterschichten befindet;
Ausbilden einer zweiten dielektrischen Schicht (33), welche den ersten Graben (32) auskleidet und einen Teil der ersten dielektrischen Schicht (30) bedeckt;
Ausbilden einer dritten dielektrischen Schicht (34) über den Halbleiterschichten, der ersten dielektrischen Schicht (30) und der zweiten dielektrischen Schicht (33);
Ausbilden eines zweiten Grabens (40), der sich durch die dritte dielektrische Schicht (34) erstreckt und einen Boden aufweist, der sich in dem ersten Graben (32) auf der Oberfläche der zweiten dielektrischen Schicht (33) oder in dieser befindet und sich über einen Teil der zweiten dielektrischen Schicht (33) auf der ersten dielektrischen Schicht (30) erstreckt; und
Ausbilden einer Gate-Elektrode (24), welche den zweiten Graben (40) füllt;
wobei das Ausbilden der zweiten dielektrischen Schicht (33) das Züchten einer einkristallinen AlN-Schicht (104) auf dem Boden (38) des ersten Grabens (32) bei einer Temperatur von über 900 °C und von unter 1.100 °C umfasst;
Züchten einer polykristallinen AlN-Schicht (102) bei einer Temperatur von über 300 °C und von unter 600 °C auf der einkristallinen AlN-Schicht (104); und
Ausbilden einer isolierenden Schicht, die SiN umfasst, auf der polykristallinen AlN-Schicht.

2. Verfahren nach Anspruch 1, wobei dieses ferner folgendes umfasst:
Bereitstellen eines Substrats (12), das Silizium, Siliziumkarbid, Saphir, Galliumnitrid oder Aluminiumnitrid umfasst;
wobei sich die Mehrzahl von Halbleiterschichten auf dem Substrat (12) befindet und folgendes umfassen:
eine III-Nitrid-Kanalschicht (16); und
eine Sperrschicht (18) über der Kanalschicht (16);
wobei:
die Kanalschicht (16) GaN umfasst und eine Dicke im Bereich von 5 Nanometern bis zu einigen Mikrometern aufweist;
die Sperrschicht (18) AlGaN mit einer Dicke im Bereich von 1 bis 30 Nanometern umfasst und mit einer Al-Zusammensetzung von 25%; und
wobei ein Abstand (36) zwischen einer Grenzfläche der Kanalschicht (16) und der Sperrschicht (18) und dem Boden (38) des ersten Grabens (32) größer oder gleich 0 Nanometer und kleiner oder gleich 10 Nanometer beträgt.

3. Verfahren nach Anspruch 1, wobei:
das Ausbilden der ersten dielektrischen Schicht (30) das Abscheiden von SiN bei einer Temperatur von über 600 Grad Celsius durch metallische organische chemische Gasphasenabscheidung umfasst; und wobei
das Ausbilden der dritten dielektrischen Schicht (34) das Abscheiden von SiN bei einer Temperatur von unter 500 Grad Celsius durch plasmaunterstützte chemische Gasphasenabscheidung umfasst.

4. Verfahren nach Anspruch 1, wobei:
die erste dielektrische Schicht (30) SiN mit einer Dicke von 1 nm bis 100 nm umfasst; und wobei
die dritte dielektrische Schicht (34) SiN mit einer Dicke von 10 nm bis 500 nm umfasst; wobei
das Ausbilden der zweiten dielektrischen Schicht (33) ferner das Ausbilden einer isolierenden SiN-Schicht (100) mit einer Dicke von 1 nm bis 50 nm auf der polykristallinen AlN-Schicht (102) umfasst.

5. Verfahren nach Anspruch 1, wobei:
die einkristalline AlN-Schicht (104) bis zu 2 nm dick ist; und wobei
die polykristalline AlN-Schicht (102) 1 nm bis 50 nm dick ist.

6. Verfahren nach Anspruch 1, wobei:
die erste dielektrische Schicht (30) nur in einem Gate-Bereich ausgebildet wird, und wobei die zweite dielektrische Schicht (33) die erste dielektrische Schicht (30) in dem Gate-Bereich bedeckt.

7. Verfahren nach Anspruch 1, wobei:
die erste dielektrische Schicht (30) so ausgebildet wird, dass sie sich von der Source-Elektrode (20) zu der Drain-Elektrode (22) erstreckt, und wobei die zweite dielektrische Schicht (33) die erste dielektrische Schicht (30) nur in dem Gate-Bereich bedeckt; oder wobei
die erste dielektrische Schicht (30) so ausgebildet wird, dass sie sich von der Source-Elektrode (20) zu der Drain-Elektrode (22) erstreckt, und wobei die zweite dielektrische Schicht (33) die erste dielektrische Schicht (30) bedeckt und sich von der Source-Elektrode (20) zu der Drain-Elektrode (22) erstreckt.

8. Verfahren nach Anspruch 1, wobei:
die erste dielektrische Schicht (30) einen Ätzstopp zur Musterung der zweiten dielektrischen Schicht (33) umfasst; und wobei:
das Ausbilden des ersten Grabens (32) Ätzen umfasst; und wobei
das Ausbilden des zweiten Grabens (40) Ätzen umfasst, und wobei die zweite dielektrische Schicht (33) einen Ätzstopp bereitstellt.

## Revendications

1. Procédé de fabrication d'un transistor à effet de champ en nitrure-III normalement fermé comprenant les étapes consistant à :
former une pluralité de couches semi-conductrices ;
former une électrode source (20) en contact avec au moins l'une des couches semi-conductrices
former une électrode drain (22) en contact avec au moins l'une des couches semi-conductrices ;
former une première couche diélectrique (30) couvrant une partie d'une surface supérieure des couches semi-conductrices entre l'électrode source (20) et l'électrode drain (22) ;
former une première tranchée (32) s'étendant à travers la première couche diélectrique (30) et ayant une partie inférieure (38) située dans l'une des couches semi-conductrices ;
former une deuxième couche diélectrique (33) bordant la première tranchée (32) et couvrant une partie de la première couche diélectrique (30) ;
former une troisième couche diélectrique (34) sur les couches semi-conductrices, la première couche diélectrique (30) et la deuxième couche diélectrique (33) ;
former une seconde tranchée (40) s'étendant à travers la troisième couche diélectrique (34) et ayant une partie inférieure située dans la première tranchée (32) sur la surface ou à l'intérieur de la deuxième couche diélectrique (33), et s'étendant sur une partie de la deuxième couche diélectrique (33) sur la première couche diélectrique (30) ; et
former une électrode grille (24) remplissant la seconde tranchée (40) ;
la formation de ladite seconde couche diélectrique (33) comprenant les étapes consistant à :
faire croître une couche AIN monocristalline (104) au niveau de la partie inférieure (38) de la première tranchée (32) à une température supérieure à 900 °C et inférieure à 1 100°C;
faire croître une couche AIN polycristalline (102) à une température supérieure à 300 °C et inférieure à 600 °C sur la couche AIN monocristalline (104) ; et
former une couche isolante comprenant du SiN sur la couche AIN polycristalline.

2. Procédé selon la revendication 1 comprenant en outre les étapes consistant à :
fournir un substrat (12) comprenant du silicium, du carbure de silicium, du saphir, du nitrure de gallium ou du nitrure d'aluminium ;
la pluralité de couches semi-conductrices étant sur le substrat (12) et comprenant :
une couche de canal (16) en nitrure III ; et
une couche barrière (18) sur la couche de canal (16) ;
la couche de canal (16) comprenant du GaN et ayant une épaisseur comprise entre 5 nanomètres et quelques micromètres ; et
la couche barrière (18) comprenant de l'AlGaN ayant une épaisseur comprise entre 1 et 30 nanomètres et ayant une composition de 25 % d'Al; et
une distance (36) entre une interface de la couche de canal (16) et de la couche barrière (18) et la partie inférieure (38) de la première tranchée (32) étant égale ou supérieure à 0 nanomètre et inférieure ou égale à 10 nanomètres.

3. Procédé selon la revendication 1 :
la formation de la première couche diélectrique (30) comprenant l'étape consistant à déposer du SiN à une température supérieure à 600 degrés centigrades par dépôt chimique en phase vapeur métal-organique ; et
la formation de la troisième couche diélectrique (34) comprenant l'étape consistant à déposer du SiN à une température inférieure à 500 degrés centigrades par dépôt chimique en phase vapeur activé par plasma.

4. Procédé selon la revendication 1 :
la première couche diélectrique (30) comprenant du SiN ayant une épaisseur comprise entre 1 nm et 100 nm ; et
la troisième couche diélectrique (34) comprenant du SiN ayant une épaisseur comprise entre 10 nm et 500 nm ;
la formation de la seconde couche diélectrique (33) comprenant en outre l'étape consistant à former la couche de SiN (100) isolante avec une épaisseur de 1 nm à 50 nm sur la couche AIN polycristalline (102).

5. Procédé selon la revendication 1 :
la couche AIN monocristalline (104) ayant une épaisseur maximale de 2 nm ; et
la couche AIN polycristalline (102) ayant une épaisseur comprise entre 1 nm et 50 nm.

6. Procédé selon la revendication 1 :
la première couche diélectrique (30) n'étant formée que dans une zone de grille et la deuxième couche diélectrique (33) couvrant la première couche diélectrique (30) dans la zone de grille.

7. Procédé selon la revendication 1 :
la première couche diélectrique (30) étant formée pour s'étendre de l'électrode source (20) à l'électrode drain (22) et la seconde couche diélectrique (33) couvrant la première couche diélectrique (30) uniquement dans la zone de grille ; ou
la première couche diélectrique (30) étant formée pour s'étendre de l'électrode source (20) à l'électrode drain (22) et la seconde couche diélectrique (33) couvrant la première couche diélectrique (30) et s'étendant de l'électrode source (20) à l'électrode drain (22).

8. Procédé selon la revendication 1 :
la première couche diélectrique (30) fournissant un arrêt de gravure pour la mise en motif de la seconde couche diélectrique (33) ; et :
la formation de la première tranchée (32) comprenant l'étape consistant à graver ; et
la formation de la seconde tranchée (40) comprenant l'étape consistant à graver et la seconde couche diélectrique (33) fournissant un arrêt de gravure.
